# EUROPEAN PATENT APPLICATION

(11) **EP 4 554 342 A1**
(43) Date of publication of application: **14.05.2025**
(21) Application number: 23208971.4
(22) Date of filing: 10.11.2023
(51) Int. Cl.: H05K 1/18, H05K 3/28, H05K 1/03, H05K 3/46, H05K 3/00

(54) **COMPONENT CARRIER AND CLUSTER TO BE EMBEDDED IN COMPONENT CARRIER**

(71) Applicant: AT&S Austria Technologie & Systemtechnik Aktiengesellschaft, 8700 Leoben (AT)
(72) Inventor: Oggioni, Stefano Sergio, 8700 Leoben (AT); Kirchheimer, Karl Philipp, 9500 Villach (AT)
(74) Representative: Dilg, Haeusler, Schindelmann Patentanwaltsgesellschaft mbH

(57) **Abstract**

A cluster (100) configured to be inserted and subsequently embedded in a recess (116) provided in a component carrier (104), said cluster comprising at least one component (102), and an uncured solid resin (106) encapsulating said component (102), said uncured solid resin (106), or said at least one component (102) and said uncured solid resin (106), forming the exterior surface of said cluster (100).

## Description

The invention relates to a cluster, a method of manufacturing a cluster, a component carrier, and a method of manufacturing a component carrier.

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, mounting devices shall be mechanically robust so as to be operable even under harsh conditions.

In view of these boundary conditions, embedding of a component in a component carrier is challenging.

It is an object of the invention to provide an architecture for component carriers which allows embedding one or more components in a simple way while ensuring high mechanical integrity.

In order to achieve the object defined above, a cluster, a method of manufacturing a cluster, a component carrier, and a method of manufacturing a component carrier according to the independent claims are provided.

According to an exemplary embodiment of the invention, a cluster configured to be inserted and subsequently embedded in a recess provided in a component carrier is provided, said cluster comprising at least one component, and an uncured solid resin at least partially encapsulating said component, said uncured solid resin, or said at least one component and said uncured solid resin, forming the exterior surface of said cluster.

According to another exemplary embodiment of the invention, a method of manufacturing a cluster configured to be inserted and subsequently embedded in a recess provided in a component carrier is provided, wherein the method comprises at least partially encapsulating at least one component by an uncured flowable resin, and thereafter transforming the uncured flowable resin into an uncured reversible hardened state for fixing the at least one component in said resin.

According to still another exemplary embodiment of the invention, a component carrier is provided which comprises a stack comprising at least one electrically conductive layer structure and at least one electrically insulating layer structure, a recess formed in the stack, and at least one component embedded in the recess, wherein the recess is provided with a resin encapsulating the at least one component, said resin being fixed to said stack by a further resin provided in said recess, wherein the interface between the resin and the further resin extends along an irregular boundary surface.

According to still another exemplary embodiment of the invention, a method of manufacturing a component carrier is provided, wherein the method comprises forming a recess in a stack comprising at least one electrically conductive layer structure and at least one electrically insulating layer structure, inserting a cluster having the above mentioned features in the recess, and subsequently transforming the uncured solid resin into a flowable state so that the transformed resin interacts with the stack by the flowing resin, and thereafter further transforming the transformed resin into a cured solid state.

In the context of the present application, the term "cluster" may particularly denote a monolithic body or an integral body which can be handled as a single piece. The cluster may be in a solid phase and may hold at least one component therein being at least partially surrounded by solid uncured resin.

In the context of the present application, the term "recess" may particularly denote a cavity, groove or hole (in particular blind hole or through hole) extending through and/or into the stack. Preferably, the lateral sides and/or the bottom side and/or the upper side, and/or all the sides of the recess may be defined by layer structures of the stack.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. In particular, a component carrier may also be embodied as a flexible or semirigid substrate. A component carrier may also be a hybrid board combining different ones of the above mentioned types of component carriers.

In the context of the present application, the term "component" may particularly denote any bulky rather than layer-type block. The component may be an electronic component, such as an active (for example a semiconductor chip or semiconductor package) or passive (for instance a capacitor or an inductor) electronic component embedded or to be embedded within an interior of the component carrier. However, the component may also be a non-electronic component without electronic functionality. For example, the component may be a component with thermal functionality, such as a heat removal and/or heat spreading functionality. For example, the component may be a metal (for instance copper) block and/or ceramic block.

In the context of the present application, the term "resin" may particularly denote a solid or liquid synthetic or natural organic polymer. An example for a resin is an epoxy resin. In another example, a resin may comprise polyimide and/or polytetrafluoroethylene and/or cyanate ester resin. For instance, the resin may be a thermosetting resin.

In the context of the present application, the term "uncured resin" may particularly denote at least partially uncured resin material, in particular a polymerizable and/or cross-linkable material (such as a resin which may experience cross-linking at elevated temperature and/or pressure) and/or a resin material which is capable of polymerizing. With the definition of a "fully cured" polymer it may be meant in particular a cross-linked polymer for which there is no possibility for further chemical transformations by curing reactions even upon heating above the glass transition temperature (Tg). Furthermore, the term uncured resin may particularly denote a glassy material state, where the chemical processes hardly proceed in the time range under consideration and under storage or standard conditions, but with an increase of temperature and/or pressure, the resin may undergo a change of state becoming viscous or liquid, and acquiring the property of flowing while it progresses in the cross-linking to eventually reach the fully polymerized state. Upon completing its curing process, the previously uncured resin may become permanently solid. Consequently, the initially at least partially uncured resin may reach an irreversible hardening upon releasing applied high pressure and/or high temperature. When releasing the temporarily increased temperature and/or pressure, the initially uncured material may be already in a cured state. Thus, the initially uncured material may become cured when applying increased temperature and/or pressure for a certain time span depending on the material to be cured. Uncured polymer material may be cured by exceeding its glass temperature. In particular, the at least partially uncured resin may comprise or consist of B-stage material and/or A-stage material. By providing part of the cluster from epoxy resin, prepreg or any other B-stage material, said cluster part may be transformed (in particular to re-acquire flowable viscous or liquid properties) during lamination so that the resin may flow for interconnecting the various elements and/or for closing gaps or voids and may therefore contribute to a stable intrinsic interconnection of a component to be embedded within the component carrier under manufacture. For example, curing agents may be added into liquid (for instance epoxy) resins in the A-stage and cured until a B-stage condition is reached. The B-stage may be a solid or semi-solid thermoplastic stage. When given additional heat and/or pressure, the B-stage (for instance epoxy) resin may flow and continue to cure to a crosslinked condition or C-stage. In the C-stage, the resin may be fully cured and may permanently stay in a solid phase , such as an irreversible cross-linked state.

In the context of the present application, the term "uncured solid resin" may particularly denote an at least partially uncured resin which is in a solid or hardened phase. A resin in a solid phase may be hard and non-liquid. For example, an uncured solid resin may be in an undercooled glassy state and/or in a gel state.

In the context of the present application, the term "uncured flowable resin" may particularly denote an at least partially uncured resin which is in a liquid or viscous phase so that it can flow. A flowable resin is a resin which is not in a solid phase.

In the context of the present application, the term "uncured reversible hardened state" may particularly denote a state of an at least partially uncured resin in a solid phase that can still be transformed in a flowable state (in particular by pressure and/or heat, for example a resin having a polymerization degree in a range from 30% to 70%) for curing, and when the curing is completed, the resin in the previously uncured reversible hardened state may be converted into a permanent solid cured state. In the reversible hardened state, the at least partially uncured resin may still be capable of polymerizing or cross-linking. In the reversible hardened state, the at least partially uncured resin may be in a glassy state, but may be still made flowable due to the change in becoming a viscous liquid due to provided increased temperature and/or pressure. Upon full curing (for example a resin having a polymerization degree higher than 70% or even higher than 95%), the capability of being made flowable again, of additionally polymerizing and/or of additionally cross-linking may be lost permanently. The "uncured reversible hardened state" may also be denoted as an "at least partially uncured solid state". For example, an uncured solid resin may be in an undercooled glassy state and/or in a gel state.

In the context of the present application, the term "cured resin" may particularly denote a resin which has completed or completely undergone a curing process and is therefore incapable of being made flowable again, of polymerizing again and/or of cross-linking again. The cured resin may be in a cured irreversible hardened state. For example, cured resin may be in a C-stage.

For example, uncured resin may have a viscosity value in a range from 100 Pas to 10⁷ Pas at room temperature (A-stage may be rather low (because it may be a liquid), however B-stage may be comparably high). For instance, uncured resin may have a viscosity value in a range from 1 Pas to 10⁵ Pas (A- and B-stage) at 150°C. For example, fully cured resin may have a viscosity value in a range from 10⁷ Pas to 10⁹ Pas (in C-stage) at room temperature. For instance, fully cured resin may have a viscosity value in a range from 10⁶ to 10⁹ Pas at 150°C. However, a skilled person will appreciate that it is hard to give precise numbers since at temperatures higher than 50°C the material may start to polymerize and thereby changes the viscosity.

In the context of the present application, the term "stack" may particularly denote an arrangement of multiple planar layer structures which are mounted in parallel on top of one another.

In the context of the present application, the term "layer structure" may particularly denote a continuous layer, a patterned layer or a plurality of nonconsecutive islands within a common plane.

In the context of the present application, the term "irregular boundary surface" may particularly denote a surface at which the resin and the further resin abut with each other, defining a boundary surface in between which does not extend along a regular, defined and/or repeatable shape. The irregular boundary surface may define a non-planar boundary surface (for instance at consequent matching extension). The "irregular boundary surface" may also be denoted as a "profiled boundary surface" or as a boundary surface having a surface profile or topography.

In the context of the present application, the term "main surface" of a body may particularly denote one of two largest opposing surfaces of the body. The main surfaces may be connected by circumferential side walls. The thickness of a body, such as a stack, may be defined by the distance between the two opposing main surfaces.

According to an exemplary embodiment, a cluster may be provided which is specifically configured to be inserted as a single monolithic block and subsequently embedded and fixed in a recess (such as a cavity) in a component carrier (for example a printed circuit board). Such a cluster may comprise one or more components (such as semiconductor dies) and an at least partially uncured solid state resin encapsulating said component(s). Advantageously, such a cluster may be manufactured by encapsulating said component(s) by an uncured flowable resin which can then be transferred into an uncured reversible hardened state resin for temporarily fixing said component in said resin. This allows to handle the cluster as a single piece, for instance by a pick and place assembly, for example for insertion into a recess of the component carrier. Subsequently curing (for instance by pressure and/or heat) the uncured solid resin holding or holding together the component(s) in the cluster may then render the resin flowable and subsequently permanently solid (so as to obtain a cured resin) to thereby permanently fix the component(s) in the recess of the component carrier, for example assuring at the same time the filling of all spaces between the component(s) and the recess by said cured resin.

Preferably, the cluster resin may be fixed to a stack of the component carrier by a further resin (which does initially not form part of the cluster) in said recess. An interface between the resin and the further resin may be shaped as an irregular boundary surface being a fingerprint of the curing of the cluster resin and a further resin (such as a sheet resin) during the component embedding process. Additionally, a part of an interface between the resin and the further resin may be shaped in accordance with a regular boundary surface. For example, the regular boundary surface may be two flat areas in direct contact with each other. In another example, the interface between the resin and the further resin may have a key-lock shape, respectively to each other. Highly advantageously, the provision of a cluster with uncured solid resin and a component held therein, which can be handled as a single piece, allows to embed in a simple way also multiple components in a single recess, in particular multiple components having different heights. All this may be done for the purpose to insert the cluster as a whole into the recess (such as a cavity) of the component carrier and to subsequently cure the uncured solid resin thereof. By taking this measure, handling of a single cluster body may be sufficient, and additionally it can be ensured that, upon curing, the cluster resin may reliably fill the cavity bottom, which may be difficult to achieve when providing a sheet resin alone. This may allow to embed components in a simple way while ensuring high mechanical integrity.

In the following, further exemplary embodiments of the cluster, the component carrier, and the methods will be explained.

Preferably, the uncured flowable resin may be transformed into a not fully cured (in particular glassy) state.

Preferably, the uncured solid resin of the cluster is fully in a vitrification stage at least at the exterior surface of the cluster. More preferably, the whole uncured solid resin composing the cluster is in the vitrification stage. Additionally, the uncured solid resin of the cluster may be fully in a vitrification stage at least at the surface between the cluster and a component. Preferably, no degree of a gelling phase has been reached yet for the uncured solid resin of the cluster. This may bring the advantage of having a high fluid resin before the curing stage, filling all the spaces between the component(s) and the seat (preferably the component carrier where the cluster is fixed, more preferably the recess where the cluster is embedded).

In an embodiment, the component is not in contact with the further resin. At least the lateral extension and/or one of the two main surfaces of the component may be entirely covered by the resin. All of the main surfaces of the component may be at least partially covered by said resin. In particular, said resin may be at least partially in contact with the lateral wall of the recess. This may bring the advantage of mechanically protecting the component in the cluster and/or in the component carrier in the final state and/or during manufacture, avoiding the flowing of the further resin against the component, potentially moving it away from the original placement.

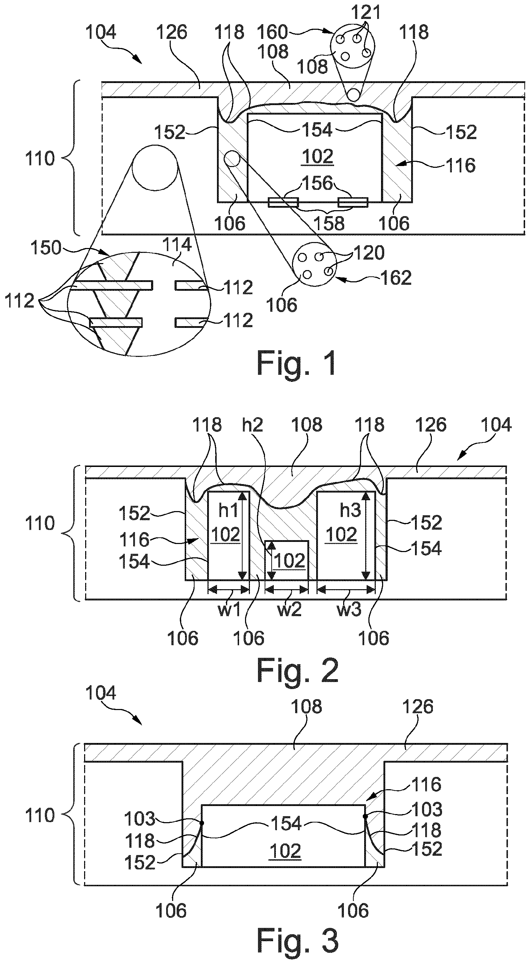

In another embodiment, the component may be in contact with the further resin (see for instance Figure 3). However, at least one side of the component may be not in contact with the further resin. It may also be possible that at least 50% or at least 70% of the surface area of the component is not in contact with the further resin.

In an embodiment, the cluster comprises a plurality of components encapsulated in the uncured solid resin. Advantageously, a plurality of components can be handled as a whole when being fixed within the uncured solid resin of the cluster. Fixation and/or immobilization of the components during the final curing stage may be enhanced by fully liquefied resin having previously not exceeded the vitrification stage. In the context of the present application, the term "vitrification stage" may particularly denote a physical state dependent on temperature and/or pressure of a material, for example a resin, which separates the physical behavior of the material. On one side of the vitrification stage, the material may have a reversible temperature and/or pressure dependent viscosity behavior. On the other side of the vitrification stage, the material may have an irreversible temperature and/or pressure dependent viscosity behavior. Preferably, the vitrification stage may be a vitrification point. An adhesive (temporary or permanent) carrier may be attached to the cluster during its formation, thereby keeping the component(s) in a target position. The preferred combination of multiple components encapsulated in the uncured solid resin in the full vitrification stage provides the advantage of a highly flowable material, avoiding any mechanical force against the component(s) during the curing caused by the movement of the uncured flowable resin toward the empty spaces, thereby assuring a reliable position maintenance between the component(s) and the component carrier. Said position maintenance may be additionally enhanced by the adhesive carrier, improving the positioning of the component(s).

In an embodiment, different ones of the plurality of components have a different height and/or a different width. Thus, the cluster concept according to exemplary embodiments may make it possible to handle a plurality of components as a whole even when they have a different height and/or width (at the same time). This may allow to overcome conventional shortcomings when inserting a plurality of components in the common recess, such as a cavity.

In an embodiment, the uncured solid resin is in an uncured reversible hardened state, which may also be denoted as an at least partially uncured solid state. The uncured resin of the cluster may be fixed with the one or more components by solidifying, for instance but not necessarily by freezing. Additionally or alternatively, the uncured resin of the cluster may be fixed with one or more components by solidifying, for example by applying stress. This may be related to a shear thickening behavior of the uncured resin. Transferring the uncured resin from the flowable state into the solid state may be accomplished in different ways, for instance thermally and/or chemically. This may bring the advantage, that the position of the component(s) embedded in the cluster and/or in the component carrier has a high accuracy, due to the fact that the one or more components may be locally fixed.

In an embodiment, the uncured solid resin covers at least part of sidewalls and/or at least part of a top wall and/or at least part of a bottom wall of the at least one component. In one embodiment, the uncured solid resin covers the entire surface of the one or more components for covering it or them hermetically. In another embodiment, the uncured solid resin covers only a part of the surface of the one or more components, for instance may leave a bottom main surface (or part thereof) of the respective component exposed beyond the cluster resin. When one or more metallic pads are located at the bottom main surface of the respective component, this may simplify establishing an electric connection with electrically conductive layer structures of the stack.

In an embodiment, the cluster has a cuboid shape or a disk shape. The cluster may be embodied as a single block of any desired shape. This simplifies handling by a pick and place apparatus.

In an embodiment, the cluster consists only of said uncured solid resin and said at least one component. For instance, it is possible that the cluster consists or substantially consists of these two elements only. This may lead to a simple construction of the cluster avoiding any kind of additional barrier for the subsequent flowing of the resin (in particular caused by the curing process).

In an embodiment, the method of manufacturing the cluster comprises transforming the uncured flowable resin into the uncured reversible hardened state by a temperature and/or pressure decrease or by only partially curing the uncured flowable resin. Preferably, the decrease of the temperature is triggered before the resin reaches the gelling state. In particular, gelation may be a critical area where as the reaction proceeds, the mixture becomes more viscous, and where in the case of chain-growth reactions, which are generally exothermic, the heat evolved may cause the reaction to become too vigorous and difficult to control progressing rapidly into an irreversible level of polymerization unless efficient cooling is used. For instance, a temperature decrease may increase the viscosity, and may in particular lead to a phase transition, for instance by freezing the resin into a solid-state. Only partially curing the uncured flowable resin may be accomplished for example by transferring a flowable A-stage resin into a solid B-state resin without curing it fully up to a C-stage.

In an embodiment, the method comprises encapsulating the at least one component by the uncured flowable resin by inserting the at least one component and the uncured flowable resin in a receptacle defining at least part of an outline of the cluster. For instance, the one or more components may be placed in the receptacle and may be immersed in at least partially liquid uncured resin inserted into the receptacle. This may ensure in a simple way a coverage of a large amount of the component surface by the resin.

Preferably, the receptacle is delimited by an adhesive bottom wall and non-adhesive sidewalls. Preferably, the bottom wall of the receptacle is formed by an adhesive sheet (for instance a sticky tape). Further preferably, the non-adhesive sidewalls of the receptacle are formed by a non-adhesive coating (such as a PTFE (polytetrafluoroethylene) coating). The adhesive bottom wall may ensure that the one or more components are temporarily fixed on the adhesive bottom wall during manufacturing the cluster. The non-adhesive sidewalls may ensure that the readily manufactured cluster can be easily removed out of the receptacle.

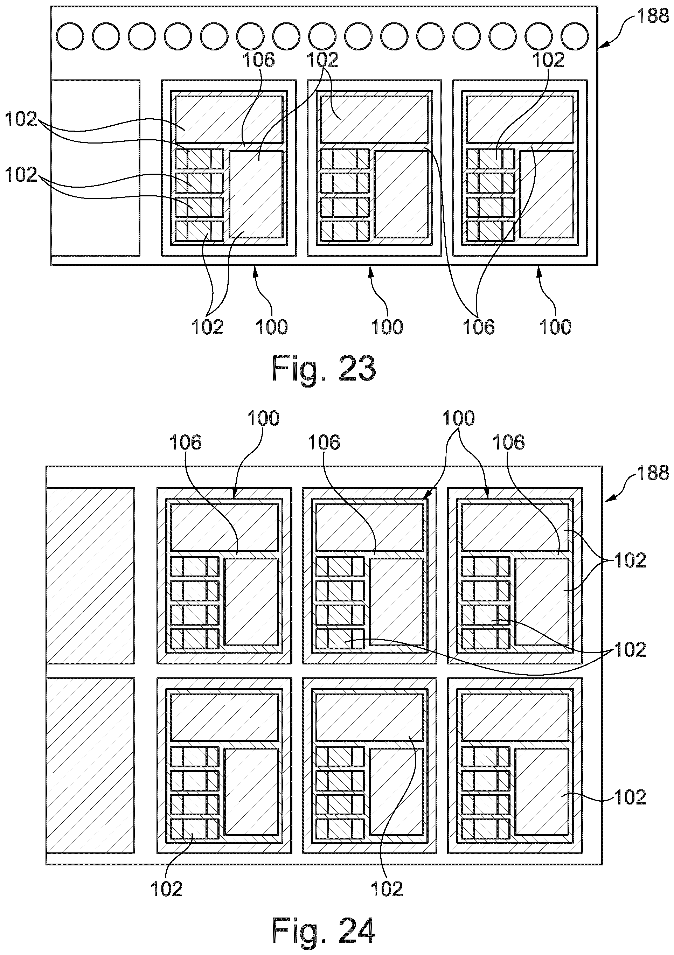

In an embodiment, a kit is provided comprising one or more clusters having the above-mentioned features (in particular according to any of the claims relating to the cluster) and a storage device holding this at least one cluster. The storage device may be configured to isolate or decouple the cluster from the external environment (in particular from at least one influence of temperature, moisture, foreign materials and/or light). The storage device may comprise a unit suitable for the indication of the temporary management of the cluster. The storage device may be configured to be integrated into subsequent process steps for the application on and/or in a component carrier. The tape and reel device of Figure 23 and the tray device of Figure 24 show examples for such a storage device.

In an embodiment of the component carrier, the at least one component is exposed at a side, in particular at a bottom side, beyond the resin. At said side, the at least one component may also be exposed beyond the further resin. In a surface region of the respective component being exposed with respect to the resin, it may be possible to electrically, optically and/or thermally couple the embedded component with the stack and/or with other parts of the component carrier.

In an embodiment, the at least one component is partially in contact with the further resin at an extension of said irregular boundary surface. More specifically, an end of the profiled or irregular boundary surface at an interface between cluster resin and stack resin may connect to the respective component, in particular to a sidewall thereof.

In an embodiment, the resin and the further resin are made of the same material. Nevertheless, an interface between the cluster resin and the stack resin may be present, and may for instance be visible in a cross-sectional view. This may lead to homogeneous properties inside of the component carrier and may thus suppress undesired phenomena such as warpage, delamination, CTE (coefficient of thermal expansion) mismatch, etc.

In another embodiment, the resin and the further resin are made of different materials. This may allow to fine-tune the properties of the component carrier and its individual constituents, even in a spatially resolved way.

Furthermore, it may be possible to use cluster resin (i.e. resin of the cluster at least partially encapsulating one or more components) and stack resin (i.e. resin of the stack, for instance originating from an initially at least partially uncured sheet laminated onto the stack) of different kind, dimension, distribution, materials, amount per volume, shape of fillers, etc. Moreover, different resin or the same kind of resin may be used with different properties (such as density, visual features). The resin and/or the further resin may affect the buffering between the resin, the at least one component and the stack. Furthermore, it may be possible to provide different properties among the resin and the further resin with respect to the electrically insulating layer structures of the stack.

In an embodiment, the resin and/or the further resin comprises filler particles. The filler particles of the resin and further resin may be the same or may differ concerning at least one property, such as material and/or material distribution, size and/or size distribution, shape, hollow, solid or porous character, and/or amount of the respective filler particles. For instance, said filler particles may be added to the respective resin to provide at least one additional functionality, such as an enhancement of thermal conductivity, an electric shielding function, enhancement of electric isolation, etc. The distribution of the filler particles may indicate the flowing direction of the resin and/or the further resin for instance during a curing process, through the different portions with different densities of said fillers defining the flow direction of the resin during curing. This may be easily recognizable for example through a cross section of the component carrier and a microscope analysis.

In an embodiment, the irregular boundary surface is a three-dimensionally curved surface. In other words, the irregular boundary surface may have a curvature in all three spatial dimensions. In an embodiment, the boundary surface defined by the interface of the two resins can be edge-free. This may bring the advantage of better adhesion between the resin and the further resin of the cluster and/or the component carrier. This may, irrespective of the unpredictable directions of the resin flow and the further resin flow to fill the open spaces, result in a full and reliable integration of the cluster with its component (s) with the component carrier.

In an embodiment, the irregular boundary surface comprises a dimple, for example a plurality of dimples, between a sidewall of the recess delimiting said resin and/or said further resin and one of the at least one component (see for instance Figure 1), and/or between neighbouring components (see for instance Figure 2). Such a dimple may be a local depression or a curved dip. A respective dimple may extend downwardly in a cross-sectional view. A multiple dimple configuration, for instance a wavy or undulation-type irregular boundary surface, may be possible as well. This may bring the advantage of creating an anchor like structure between a sidewall of the recess and a respective one of at least one component. Such an anchor like structure may impart good physical and/or mechanical adhesion and may simultaneously ensure a reliable position of the respective one of at least one component in the cluster and/or component carrier.

In an embodiment, the irregular boundary surface comprises a meniscus, for example a plurality of meniscus, between a sidewall of the recess delimiting said resin and/or said further resin and one of the at least one component (see for instance Figure 3), and/or between neighbouring components. Such a meniscus may be defined by a curved irregular boundary surface corresponding to a concave design of the resin and a convex design of the further resin. A meniscus may be crescent shaped.

The exact appearance of the irregular boundary surface may depend on adjustable material and process parameters, such as viscosity of resin and further resin in a flowable state, as well as amount and initial position of resin and/or further resin before curing.

In an embodiment, the irregular boundary surface comprises intermingled resin and further resin. Thus, resin and further resin may be mixed around the irregular boundary surface. In such an intermingling region, a mixed first resin-further resin region may be present between a pure first resin region and a pure further resin region. Such an intermingling region may lead to a smooth transition and an intimate connection between resin and further resin and therefore to a high integrity of the component carrier as a whole. The formation of an intermingling region may be promoted by a corresponding selection of the material of resin and further resin, in particular their viscosity in a flowable state. In particular, grafting between resin and further resin may occur in the intermingling region.

In an embodiment, the irregular boundary surface has chemical bonds between the resin and the further resin. Thus, the first resin and the second resin abutting against each other at the irregular boundary surface may be chemical bonded with each other. Depending on the configuration of resin and further resin, such chemical bonds may include covalent bonds and/or ionic bonds. Also this may ensure a firm mechanical connection of the constituents of the component carrier in particular around the irregular boundary surface.

In an embodiment, the irregular boundary surface has crosslinks between the resin and the further resin. Crosslinking may denote the process of forming covalent bonds or relatively short sequences of chemical bonds to join two polymer chains of resin and further resin together. Thus, carbon chains between resin and further resin may be cross-linked at the irregular boundary surface. In an example, crosslinks may comprise at least one of an ester-, an ether-, an amine-, an amide-, a sulfide-, and a thioester- functional group. This may also strengthen the mechanical integrity of the component carrier in the region around the irregular bounding surface.

In an embodiment, at least part of gaps of the recess between the at least one component and the stack is filled partially with the resin and partially with the further resin. For example, a bottom portion of the gaps may be filled with the resin, and a top portion of the gaps may be filled by the further resin. This may bring the advantage of manufacturing a cluster and/or a component carrier in an easy and reliable way using the above described methods.

In an embodiment, at least two components are embedded in the recess encapsulated in the resin. Such a configuration allows a precise positioning of the multiple encapsulated components due to the preferred previous vitrification stage of the uncured solid resin resulting in a highly flowable resin, avoiding any mechanical force against the components during the curing caused by the movement of the uncured flowable resin toward the empty spaces.

In an embodiment, the at least two components are fixed in the recess partially by the resin and partially by the further resin with a common continuous interface between the resin and the further resin, defined by the irregular boundary surface, for the at least two components. Resin and further resin may be interconnected with each other by intermingling, may be chemically bonded with each other and/or may be cross-linked or polymerized with each other at the irregular boundary surface having a surface profile. This may ensure reliable positioning of the at least two components in the cluster and/or component carrier due to the presence of the resin and the further resin in the recess created by the above described method.

In an embodiment, the method comprises filling part of gaps of the recess between the at least one component and the stack by said cured resin and filling at least another part of said gaps by a further resin. During the curing process, the cluster resin may become flowable and may therefore flow into tiny regions of the gap. The same is true for a further resin, which may be provided in the form of a liquid adhesive inserted the gaps and/or by providing a sheet with uncured further resin being attached to the stack and cluster. When curing said further resin, it may also flow into tiny regions of said gaps. Preferably, resin and further resin may entirely fill said gaps, thereby avoiding or at least substantially avoiding undesired voids in an interior of the component carrier. During curing it may be possible, that the resin and the further resin have different viscosities and/or polymerization degree. Therefore, it may be possible that the resin or the further resin is more flowable compared to the respective other of the resin or the further resin resulting in an interface between the resin and the further resin having an irregular boundary surface.

In an embodiment, said further resin interacts with said resin for forming an interface between the resin and the further resin, said interface extending along an irregular boundary surface. Said interaction may for instance include the formation of chemical bonds, and/or mutual cross-linking between resin and further resin. This may result in a reliable interconnection between the resin and the further resin, in particular at the interface having an irregular boundary surface.

In an embodiment, the method comprises curing said resin and curing said further resin simultaneously. Thus, curing of resin and further resin may occur in the same process step. This may simplify the manufacturing process. Furthermore, this may promote an intimate connection of resin and further resin at the irregular boundary surface.

In an embodiment, the method comprises curing said resin and curing said further resin by the application of mechanical pressure and/or heat. By merely supplying heat and/or mechanical pressure, curing of both resins may be triggered at the same time, thus with low effort, and ensuring that both resins are present in a flowable state at least during an overlapping temporal range.

In an embodiment, the method comprises providing the further resin as part of an initially uncured sheet attached to an upper main surface of said stack and of said cluster inserted in the recess, and thereafter curing said further resin, for example simultaneously with a curing of said resin. More precisely, a cluster may be inserted into a recess of the stack. Thereafter, an uncured resin sheet (for instance made of pure uncured resin, uncured resin and filler particles, uncured resin with reinforcing fibers, etc.) may be attached to the cluster and the stack. By pressure and/or heat, resin sheet and cluster resin may be cured at the same time.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (for example based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, for example fibers impregnated with the above-mentioned resins is called prepreg. These prepregs are often named after their properties for example FR4 or FRS, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

The at least one component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.
Figure 1 shows a cross-sectional view of a component carrier according to an exemplary embodiment of the invention.
Figure 2 shows a cross-sectional view of a component carrier according to another exemplary embodiment of the invention.
Figure 3 shows a cross-sectional view of a component carrier according to another exemplary embodiment of the invention.
Figure 4 shows a plan view of a preform of a component carrier according to another exemplary embodiment of the invention.
Figure 5 shows a cross-sectional view of the preform of Figure 4.
Figure 6 shows a cross-sectional view of a preform of a component carrier according to another exemplary embodiment of the invention.
Figure 7 to Figure 11 show cross-sectional views of structures obtained during manufacturing a component carrier according to an exemplary embodiment of the invention.
Figure 12 shows a cross-sectional view of a component carrier according to another exemplary embodiment of the invention.
Figure 13 to Figure 19 show cross-sectional views of structures obtained during manufacturing a cluster according to an exemplary embodiment of the invention.
Figure 20 and Figure 21 show plan views of a cluster according to an exemplary embodiment of the invention.
Figure 22 shows a plan view of a preform of a component carrier according to another exemplary embodiment of the invention.
Figure 23 shows a plan view of a storage device for storing and handling clusters according to an exemplary embodiment of the invention.
Figure 24 shows a plan view of a storage device for storing and handling clusters according to another exemplary embodiment of the invention.
Figure 25 to Figure 29 show plan views of structures obtained during manufacturing clusters for component carriers according to an exemplary embodiment of the invention.
Figure 30 shows a phase diagram and a timing diagram relating to a method of manufacturing a cluster according to an exemplary embodiment of the invention.

The illustrations in the drawings are schematical. In different drawings, similar or identical elements are provided with the same reference signs.

Before, referring to the drawings, exemplary embodiments will be described in further detail, some basic considerations will be summarized based on which exemplary embodiments of the invention have been developed.

The embedding of components in a component carrier is conventionally addressed during the construction of the component carrier (such as a substrate). For instance, a component carrier may be used to carry complex semiconductor components to be used for example in computational modules. The embedding of multiple components may be desired to increase the functionalities provided by the component carrier, and to advance the performance of a module in its entirety.

What concerns embedding of components into substrates, conventional methods encounter limitations driven by the typology of components, their dimensional and structural characteristics, as well as limitations in the supply chain availability (for example providing components to be at the same dimensional height).

There is an increasing demand to consider further levels of integrations of components into substrates. These new directions bring to the research and formulation of processes for integrating multiple components into the same recess spaces (with limitations in the horizontal plane). Embedding of multiple components with different height, due to the characteristics of the embedding or lamination process, into the same core recess becomes quite difficult, and sometime even impossible. A major requirement is to have the thickness of the substrate core, to be used in the construction, to be as thick as the component(s) required to be embedded. The embedding becomes even more difficult when components have different heights. The bigger the gap in the height between them, the worse the possibility to successfully implement their coexisting embedding, even if these are placed in different cavities of a stack, e.g. when not desired by design, to leave portions of the cavity volume unfilled with resin.

According to an embodiment of the invention, a cluster is provided for being handled as a single body for insertion and fixation in a recess of a component carrier (for example a PCB or an IC substrate). Advantageously, said cluster may be formed with any desired number of components (i.e. one or more) fixed, for simplifying subsequent handling, within uncured solid resin of the cluster. Said cluster can be formed in a convenient way by inserting said one or more components in uncured flowable (such as liquid or viscous) resin. The latter can be converted into a still at least partially uncured hardened state so that said component(s) is or are fixed in place within the solid resin, which is nevertheless still curable. The cluster can then be picked and placed into a recess (such as a cavity) of the component carrier. Thereafter, the cluster resin may be cured for example by pressure and/or heat and/or UV (ultraviolet) light, which may trigger processes such as polymerizing and/or cross-linking. Thereby, the previously solid uncured cluster resin may become flowable, may be fully cured and may thereby be converted into a permanent solid state. This may glue the component(s) in place in the recess of the component carrier.

In particular, it is possible that the cluster resin (i.e. the resin of the cluster) may be connected with a further resin (such as a sheet resin, i.e. a resin of an initially at least partially uncured sheet) provided separately from the cluster into said recess. Alternatively, the further resin may be provided simultaneously with the cluster into the recess. A profiled or irregular boundary surface may be formed between the cluster resin and the further resin, when both are cured and interact in the recess. Additionally, a regular boundary surface, for example a flat surface, may be formed at one partial area between the cluster resin and the further (or sheet) resin. Embedding one or more components in uncured solid resin of a cluster to provide a semifinished product for a component carrier manufacturing process enables to execute an embedding process in an easy way by handling the cluster as a single piece during embedding. In addition to the simple manufacture, a reliable mechanical connection between stack and component may be ensured by such a manufacturing architecture.

In a preferred embodiment, clusters of one or more components embedded with uncured solid resin into a monolithic structure are created in a way that is compatible with a process of embedding the component(s) into a stack (for instance comprising one or more Printed Circuit Board cores). In particular, such a cluster may comprise resin-interconnected components with different heights and/or similar, in particular same, heights and may be embedded as a single unit into a recess of the component carrier stack. Such a cluster may be shaped and dimensioned so as to fit into the recess with a normalized height defined by the resin. Hence, less volume of further resin may be sufficient to fill the remaining portion of the recess (such as a cavity). This may allow a seamless immersion embedding of one or more components into substrates, advantageously with very low stress in the assembly. Furthermore, such a manufacturing architecture may enable a complete immersive embedding of multiple components at the same time, and may replace multiple pick and place steps by a single placement step in the substrate. Furthermore, the described concept may simplify the use of further resin (i.e. prepregs) to fill normalized empty spaces in a recess or recesses of the stack. In view of the foregoing, exemplary embodiments may provide a significant improvement of productivity and yield, and may enable manufacture of component carrier architectures otherwise considered too difficult to be produced. Further shortcomings of conventional substrate manufacture, such as alignment issues, issues with subassemblies, etc. may be overcome by exemplary embodiments.

An embodiment provides a construction of clusters of components for placement into a substrate recess as a single body in place of the placement of multiple individual components. Electric interconnection of the components belonging to the cluster may be provided using laser via technology and/or other methods, for example using a sinter paste or via diffusion bonding. Achieving the possibility of embedding multiple components of different typology into a recess of a component carrier represents a strong opportunity of solving major functional shortcomings in the semiconductor and system fields. The opportunity of implementing a method capable to overcome many of the present shortcomings concerning embedding may allow to seamlessly implement embedding of different types of components, with different provenience, with different physical dimensions, into organic substrates.

In particular, exemplary embodiments of the invention may enable the embedding of active devices together with other types of components like different kind of capacitors, resistors or inductors, which represent very specific thicknesses and with pretty significant variation in their dimensional values, with wide tolerances, when compared to bare semiconductor devices.

According to an exemplary embodiment, the embedding of components into a substrate can be performed within design and/or construction rules that would have a recess for each component. Providing clusters of components with interconnecting resin may be applicable to either integration conditions. The creation and assembly of these clusters may allow to assemble active and passive components together, since it allows the placing of components with very different dimensions together. One conventional shortcoming which may be overcome by exemplary embodiments of the invention is the component skew, being a limitation in the current technology. The components placed within the same recess in past may lead to a shift away from their original position and/orientation during the press or lamination steps, this shift and/orientation may represent a significant impact in the performance of the device or, by the nature of the embedding process, even an unrecoverable failure.

To put it shortly, a manufacturing process according to an exemplary embodiment may be as follows: Firstly, one or more components may be embedded in a liquid resin to form a preform of a cluster. Thereafter, the cluster is solidified, without fully curing the resin (thereby remaining in an at least partially uncured solid state). The solidified cluster may then be inserted as a single piece into a cavity of a component carrier stack. By lamination, the resin of the cluster may be fully cured, so that the one or more components are fixed in place in the recess of the stack.

Moreover, the creation of clusters according to an exemplary embodiment of the invention may enable the implementation of a wide variety of components and density factors, such as number of cavities per package and number of components into each recess (for instance cavity), but without increasing cumulatively the level of process challenges for the embedding.

In particular, an exemplary embodiment of the invention offers the possibility of implementing the embedding of clusters of components into a core construction of a component carrier regardless of the thicknesses of the components. Furthermore, exemplary embodiments may be capable of reducing or even minimizing the process cycle of the component carrier panel manufacturing process reducing the number of parts to be placed into the cavities, for example one in place of many. Apart from this, exemplary embodiments may adopt a process flow that is compatible to the right positioning of the different components with a greatly reduced risk of a possible shift of their position. Furthermore, exemplary embodiments provide an opportunity for managing a supply chain for these parts for embedding, reducing the time to go through the production line. Advantageously, the manufacturing architecture according to exemplary embodiments may be compatible with existing elements of embedding processes into a component carrier core. Advantageously, component clusters may be pre-formed outside of a panel process. Clusters according to exemplary embodiments can be freely designed, for example these can be of different size, with different components but, at substrate process point of view, each one of them may involve only a single placement into a recess. Further advantageously, the same process can be applied to clusters of different dimensions bearing customized groups of components, to a limited group of components to be embedded, and where is needed to reach compatibility of the different components (or components of different dimensions) into a specific configuration of embedding into substrates with other component(s).

To put it shortly, an exemplary embodiment constructs clusters of components for enabling their placement into a component carrier recess (such as a substrate cavity) as a single body in place of the placement of multiple individual components. Interconnections of the components belonging to the cluster may be formed by laser via technology. Formation of the cluster with at least one component surrounded at least partially by resin may for instance be accomplished by immersing the at least one component in uncured flowable resin and subsequently hardening the latter. In this context, also a molding process may be carried out, wherein care should be taken that the resin is not entirely cured at the end of the cluster formation process, but is still present in an at least partially uncured solid state.

**Figure 1** illustrates a cross-sectional view of a component carrier 104 according to an exemplary embodiment of the invention. In the shown embodiment, component carrier 104 is embodied as a printed circuit board (PCB). However, component carrier 104 may also be an integrated circuit (IC) substrate, etc.

Component carrier 104 according to Figure 1 comprises a laminated layer stack 110 comprising a plurality of electrically conductive layer structures 112 and of electrically insulating layer structures 114, see detail 150.

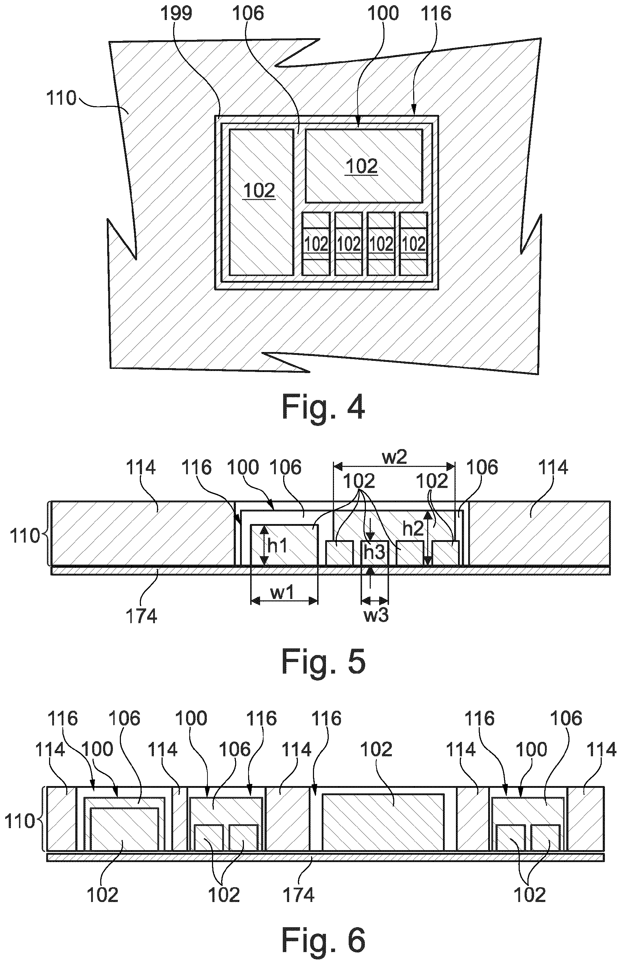

Detail 150 illustrates a stack 110 of layers and vias in a build-up construction. However, it may also be possible to embed one or more clusters 100 (see for instance Figures 4 to 6) into one or more cores. It is in particular possible that a stack 110 is provided being embodied with a core in a layers stack. Furthermore, it may be possible to provide the cluster(s) 100 into build up layers.

The electrically conductive layer structures 112 may comprise patterned copper layers which may form horizontal pads and/or a horizontal wiring structures. Additionally, the electrically conductive layer structures 112 may comprise vertical through connections such as copper pillars and/or copper filled laser vias. Additionally or alternatively, mechanical plated through holes (PTH) may also be used as vertical through connections. Moreover, the stack 110 of the component carrier 104 may comprise one or more electrically insulating layer structures 114 (such as one or more prepreg sheets, resin sheets or cores made of FR4). Ajinomoto Build-Up Film ^{®} (ABF) materials are also possible for at least part of the electrically insulating layer structures 114, in particular when the component carrier 104 is embodied as an IC substrate. Also surface finish (like ENIG or ENEPIG, a solder resist, etc.) may be optionally applied on the top side and/or on the bottom side of the stack 110 (not shown).

As shown as well in Figure 1, a recess 116 is formed in the stack 110. For example, recess 116 may be a cavity. An electronic component 102, which is here embodied as a semiconductor die, is embedded in the recess 116. However, the electronic component 102 may also be a passive component, such as a capacitor component. It is furthermore possible that the electronic component 102 is substituted by or supplemented by a non-electronic component, such as a copper or ceramic block for heat dissipation purposes.

In gaps between electronic component 102 and sidewalls 152 as well as a bottom wall of the recess 116 in stack 110, the recess 116 is filled partially with a resin 106 and partially with a further resin 108. As shown, the resin 106 fully encapsulates the electronic component 102 and contributes to fix in place the electronic component 102 in the recess 116. Moreover, said resin 106 is fixed to said stack 110 also by further resin 108 provided in an upper portion of said recess 116 and provided on top of stack 110.

As shown as well, the interface between the resin 106 and the further resin 108 extends along an irregular boundary surface 118. Irregular boundary surface 118 is a three-dimensionally curved and profiled surface with a dimple structure between sidewalls 152 of stack 110 delimiting the recess 116 and sidewalls 154 of the electronic component 102. As shown, the gaps of the recess 116 between the opposing sidewalls 152, 154 of the component 102 and the stack 110 are filled partially with the resin 106 and partially with the further resin 108. As can be taken from Figure 1 as well, the electronic component 102 may be exposed at a bottom side beyond the resin 106. This may ensure that one or more metallic pads 156 of the electronic component 102 may be electrically coupled with metallic pads 158 of the electrically conductive layer structures 112 of stack 110. Additionally or alternatively, metallic pads 156 of the electronic component 102 may be located on the opposed (i.e. top) side of the component 102 and may be connectable via for example laser vias to the electrically conductive layer structure(s) 112.

Selectively, the resin 106 and the further resin 108 may be made of the same material or may be made of different materials. Using identical resins 106, 108 may ensure a homogeneous surrounding of the embedded electronic component 102. Using different resins 106, 108 may allow to separately fine-tune the resin properties in different regions surrounding the embedded electronic component 102. As shown in details 160, 162 of Figure 1, the resin 106 and the further resin 108 may comprise filler particles 120, 121, which may be different or the same. By said filler particles 120, 121 an additional functionality may be added to the respective resin 106 or 108, such as an enhancement of thermal conductivity, an electromagnetic shielding function, etc.

Different configurations are possible for the irregular boundary surface 118 depending on the material properties of the resins 106, 108 and the processing conditions during a manufacturing process:
In one configuration, intermingled resin 106 and further resin 108 may be present at irregular boundary surface 118. Descriptively speaking, a mixture of intermingled resin 106 and further resin 108 may be present at the irregular boundary surface 118. On one side of said intermingling region, pure resin 106 with filler particles 120 may be present, whereas the further resin 108 with filler particles 121 may be present at the opposing other side of said intermingling region. Such an intermingling region may lead to a smooth transition between the properties of resin 106 and further resin 108, and may thereby suppress thermal load, for instance in the event of different coefficients of thermal expansion (CTE) of resin 106 and further resin 108.

In another configuration, the irregular boundary surface 118 has chemical bonds between the resin 106 and the further resin 108. Thus, the resins 106, 108 may be configured for creating chemical bonds, such as covalent and/or ionic bonds, in between, for instance during curing. Additionally or alternatively, the irregular boundary surface 118 may have physical bonds between the resin 106 and the further resin 108 created by for example Van der Waals forces and/or hydrogen bond forces. This may strengthen the mechanical integrity of the component carrier 104 as a whole.

In still another configuration, the irregular boundary surface 118 has crosslinks between the resin 106 and the further resin 108. Upon polymerizing, resins 106, 108 may form interconnections at their carbon chains. In an example, crosslinks may comprise one or more of ester-, ether-, amine-, amide-, sulfide-, thioester- functional groups. Such a cross-linking between the resins 106, 108 may suppress delamination and other undesired artefacts. Moreover, cross linking between the resin 106 and/or the further resin 108 with the electrically insulating layer structures 114 of the stack 110 may occur or may be triggered.

The component carrier 104 of Figure 1 can be manufactured using a cluster 100 (see for instance Figure 4 to Figure 6) according to an exemplary embodiment, which comprises component 102 being partially surrounded by solid uncured resin 106. Such a cluster 100 may be inserted as a whole in recess 116 of stack 110. Thereafter, an initially uncured resin sheet 126, comprising uncured further resin 108, may be attached to the upper main surface of stack 110 and to the upper main surface of the cluster 100. The uncured resins 106, 108 may then be cured simultaneously by the application of heat and/or pressure, and component carrier 104 of Figure 1 is obtained. The cavity or recess 106 may be defined with at least one vertical sidewall. Additionally or alternatively, the sidewall defining the cavity or recess 106 may be inclined.

**Figure 2** shows a cross-sectional view of a component carrier 104 according to another exemplary embodiment of the invention.

The embodiment according to Figure 2 differs from the embodiment according to Figure 1 in particular in that, according to Figure 2, three components 102 are embedded in the same recess 116 and are encapsulated in the resin 106. As shown as well, the three components 102 are fixed in the recess 116 partially by the resin 106 and partially by the further resin 108 with a common continuous interface between the resin 106 and the further resin 108. Said interface is defined by the irregular boundary surface 118 in common for all three components 102. Irregular boundary surface 118 comprises dimples between facing sidewalls 152, 154 of the laterally outermost components 102 and the stack 110, as well as between the laterally outermost components 102 and above the central one of the components 102. As shown, the three components 102 have different heights h1, h2, h3 and different widths w1, w2, w3. Alternatively, two of the three components 102 may have different heights h1, h2 or h1, h3 or h2, h3 and different widths w1, w2 or w1, w3 or w2, w3, or the three components 102 may have similar, in particular the same heights h1=h2=h3 and similar, in particular the same widths w1=w2=w3.

Advantageously, the component carrier 104 of Figure 2 may be manufactured using a stack 110 having a single cavity-type recess 116 in which a cluster 100 according to another exemplary embodiment of the invention is inserted. Curing of resins 106, 108 may be initiated simultaneously, as described referring to Figure 1. The single-body cluster 100 according to this embodiment comprises the three components 102 being partially surrounded by solid uncured resin 106. This allows handling only a single cluster 100 with three different components 102 interconnected by curable solid resin 106 despite of the fact that heterogeneous components 102 having different heights h1, h2, h3 and different widths w1, w2, w3 are to be arranged in the recess 116.

In the illustrated embodiment, the bottom of the cavity or recess 116 is planar. Alternatively, the bottom of the cavity or recess 116 may have a step. Such a step may connect, vertically or in an inclined way, two planar sections of the bottom of the recess 116 being arranged at two different vertical levels. This may bring the advantage of an easy and reliable accommodation of a plurality of components 102 having a different spatial position. It may also be possible that at least one of the at least one component 102 has a stepped bottom. The stepped bottom of such a component 102 may correspond to a stepped bottom of the recess 116. Also this may allow assembly of a respective component 102 in the recess 116 with high spatial accuracy.

**Figure 3** shows a cross-sectional view of a component carrier 104 according to another exemplary embodiment of the invention.

The embodiment according to Figure 3 differs from the embodiment according to Figure 1 in particular in that, according to Figure 3, the irregular boundary surface 118 comprises two meniscus, each between a respective sidewall 152 of the recess 116 delimiting said resin 106 and said further resin 108 and a respective sidewall 154 of component 102. According to Figure 3, resin 106 covers a lower part of the sidewalls 154 of component 102, whereas resin 108 covers an upper part of the sidewalls 154 and the upper main surface of component 102. In Figure 3, the component 102 is partially in contact with the resin 106 and the further resin 108 at an extension of said irregular boundary surface 118. More precisely, the irregular boundary surface 118 contacts sidewalls 154 of the component 102 according to Figure 3 (see contact points 103).

Also component carrier 104 of Figure 3 can be manufactured using a cluster 100 similar to the one described above referring to Figure 1. The type and amount of resin 106 in comparison with the type and amount of further resin 108 may have an influence on the design of the irregular boundary surface 118. Additionally, a portion of the top side of the component 102 may be in direct contact with the resin 106 and another portion of the top side of the component 102 may be in direct contact with the further resin 108. Further additionally, the further resin 108 may be in direct contact with a portion of the bottom side of the cavity or recess 116.

**Figure 4** shows a plan view of a preform of a component carrier 104 according to another exemplary embodiment of the invention. **Figure 5** shows a cross-sectional view of the preform of Figure 4. More specifically, each of Figure 4 and Figure 5 illustrates a stack 110 with a cavity-type recess 116 in which a cluster 100 according to an exemplary embodiment of the invention has been inserted by a pick and place assembly. Recess 116 in stack 110 is formed as a through hole, so that a temporary carrier 174 (such as a sticky tape) may be connected to a bottom main surface of the stack 110 for closing the through hole prior to assembling cluster 100. A lateral gap between the cluster 100 and the stack 110 is denoted with reference sign 199.

Said cluster 100 is already inserted and may be subsequently embedded in the recess 116 provided in the component carrier 104 being presently manufactured. Said cluster 100 comprises a plurality of components 102 with have different heights h1, h2, h3 and different widths w1, w2, w3. An uncured solid resin 106, such as epoxy resin in B-stage encapsulates and holds together said components 102 within cluster 100. Additionally or alternatively, the uncured solid resin 106 may comprise cyanate ester resin, benzocyclobutene resin, bismaleimide-triazine resin, polyphenylene derivate (for example based on polyphenylenether, PPE), polyimide (PI), polyamide (PA), liquid crystal polymer (LCP), polytetrafluoroethylene (PTFE) and/or a combination thereof. Consequently, cluster 100 can be handled as a single piece and is provided with a solid resin 106 which is capable of becoming flowable and thereafter permanently solid by curing under elevated temperature and/or pressure and/or UV radiation. Said components 102 and said uncured solid resin 106 together form the exterior surface of said cluster 100. More specifically, the uncured solid resin 106 forms the entire lateral sidewalls of the cluster 100, whereas the upper and lower main surfaces of cluster 100 are partially formed by resin 106 and by components 102. As already mentioned, the uncured solid resin 106 is in an uncured reversible hardened state, i.e. is solid enabling handling of cluster 100 as a single piece. The uncured solid resin 106 covers sidewalls and part of a top wall of the respective components 102. As shown, the cluster 100 has a cuboid shape. Alternatively, the cluster 100 may have a round shape, for example a cylindrical shape. Since the cluster 100 of Figure 4 and Figure 5 consists only of said uncured solid resin 106 and said components 102, it has a very simple construction. For example, the components 102 may be active components (for instance manufactured in Si, SiC, GaN, GaAs, SiGe technology) and/or may be passive components (such as capacitors, inductors or ohmic resistors).

Hence, Figure 4 and Figure 5 show a cluster 100 of components 102 with different heights being embeddable as a single unit compatible to fit into the recess 116 with a normalized height by the uncured resin 106 holding the components 102 together. Advantageously, less volume is required for prepreg resin (see reference sign 126 in Figure 1 to Figure 3) to fill the remaining portion of the recess 116 which is not filled by the components 102 and resin 106.

Moreover, Figure 4 and Figure 5 show that the smallest components 102 overlap in area with the largest component 102 behind. However, the area of the smallest left and right components 102 do not completely overlap with the area of the largest component 102.

**Figure 6** shows a cross-sectional view of a preform of a component carrier 104 according to another exemplary embodiment of the invention.

The embodiment according to Figure 6 differs from the embodiment according to Figure 4 and Figure 5 in particular in that, according to Figure 6, stack 110 comprises a plurality of cavity-type recesses 116 each being filled with a respective cluster 100. The different clusters 100 of Figure 6 are of different type. As shown, components 102 with different heights and widths are arranged in the multiple cavities. To put it shortly, different volumes to be filled into each single recess 116 are foreseen in Figure 6.

As shown, multiple cavities may be filled with mixed components 102 being immobilized by a solid uncured resin 106 within monolithic blocks forming said clusters 100.

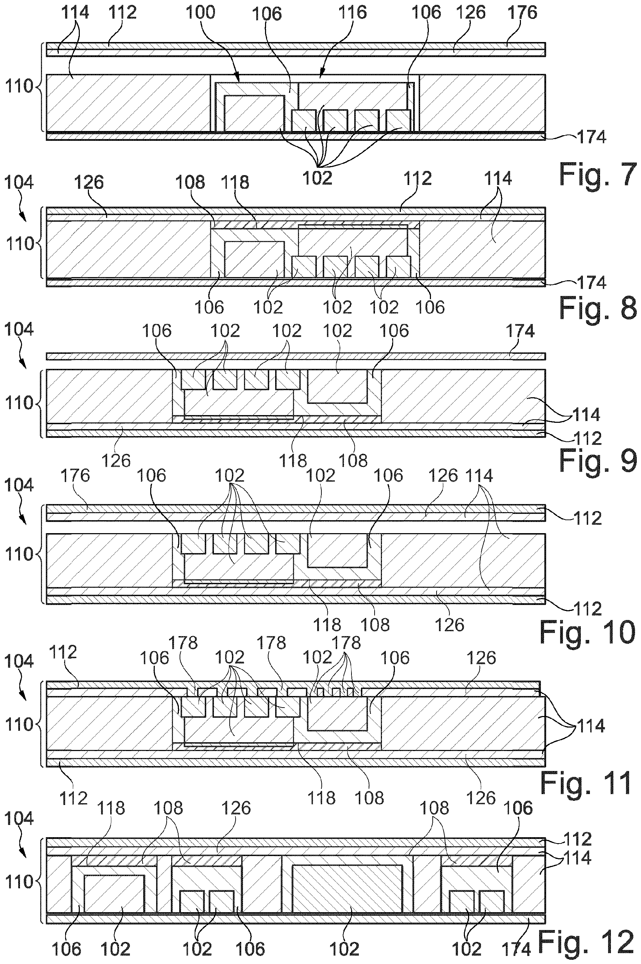

Figure 7 to Figure 11 show cross-sectional views of structures obtained during manufacturing a component carrier 104 according to an exemplary embodiment of the invention.

Referring to **Figure 7****,** the arrangement of stack 110, cluster 100 inserted in recess 116 and attached temporary carrier 174 according to Figure 5 is shown. Figure 7 shows a single recess 116 with multiple components 102 immobilized within a monolithic block in form of cluster 100 by uncured solid resin 106. Above said arrangement, a double layer comprising a metal foil 176 and a partially uncured resin sheet 126 (which may be a pure resin sheet or a prepreg sheet) are arranged. While the cluster 100 is the source of resin 106, the resin sheet 126 is the source of further resin 108. Thus, the further resin 108 is provided as part of initially uncured sheet 126 which is to be attached to an upper main surface of said stack 110 and of said cluster 100 inserted in the recess 116. Resin sheet 126 may comprise B-stage resin, and the component cluster 100 may comprise resin 106 in B-stage. Alternatively, the further resin 126 may be in A-stage (which may be a liquid stage) and/or may be applied by a printing process, for example screen printing or 3D-printing. As shown, heterogeneous components 102 may be included in the same cluster 100.

Referring to **Figure 8****,** the double layer of Figure 7 is attached to the arrangement by lamination, i.e. by the application of pressure and/or heat. Thereby, the uncured solid resin 106 is transformed into a flowable (liquid or viscous) state so that the transformed resin 106 interacts with the stack 110 by the flowing resin 106. At the same time, the further resin 108 of the resin sheet 126 is transformed into a flowable (liquid or viscous) state so that the transformed further resin 108 also interacts with the stack 110 by the flowing further resin 108. For example, temperature and/or pressure may be applied to at least partially liquefy or make the resin 106 and further resin 108 flowable (in particular at the same time). In particular, the resin 106 and further resin 108 may be triggered for polymerizing and/or cross-linking and are thereby both transformed into a cured solid state. As a consequence, gaps of the recess 116 between the components 102 and the stack 110 are filled by said cured resin 106 and by said cured further resin 108. As illustrated schematically in Figure 8, said further resin 108 interacts with said resin 106 for forming an interface between the resin 106 and the further resin 108, said interface extending along an irregular boundary surface 118 (for instance having dimples and/or a meniscus, or another three dimensional curvature, see for instance Figure 1 to Figure 3, not shown in Figure 8). By the described process, said resin 106 and said further resin 108 are cured simultaneously, i.e. by a common lamination process. Resins 106, 108 are solidified in recess 116 and thereby fix the components 102 of the former cluster 100 in place.

The monolithic cluster 100 can be supplied to feeders of an automatic pick and place apparatus through trays (see for instance Figure 24), tape and reels (see for instance Figure 23), or other methods. Within application-dependent design rules, the resin 106 of the monolithic cluster 100 including the one or more components 102 can be the major contributor in the filling of the recess 116, wherein the remaining portion of the resin content of the laminated prepreg may fill a small (or even minimum) portion of the left over volume space of recess 116. During lamination, the thermosetting B-stage resin 106 may still flow filling at least partially the gap between the block-type cluster 100 and the walls of stack 110 delimiting the recess 116. The more the volume of the recess 116 is filled by the resin 106 of the cluster 100, the less resin flow is required from the prepreg-based further resin 108 to fill the remaining portion of the space of recess 116. Alternatively, the resin 106 and/or the further resin 108 may comprise voids filled with gas.

The level of filling of the recess 116 may be mostly driven by the performance of the resin 106 in the cluster 100. It may be preferred to have a controlled height to achieve the required volume ratio between components 102, the dimensions of recess 116, and the volume of the resins 106, 108.

The concept of using monolithic blocks in form of clusters 100 makes it dispensable to align the core thickness to the component thickness even when the core thickness is required to be substantially thicker than the thickness of the components 102 to be embedded.

Referring to **Figure 9****,** the structure according to Figure 8 is turned upside down, and the temporary carrier 174 is removed.

Referring to **Figure 10****,** a further double layer comprising a further metal foil 176 and a further partially uncured resin sheet 126 are arranged on top of the structure of Figure 9. Alternatively, other techniques may be applied. For example, it may be possible to apply the uncured resin 108 by a printing process, followed by a curing process, and thereafter applying the metal by a metal deposition process, for example plating or physical vapour deposition.

Referring to **Figure 11****,** the further double layer is connected to the stack 110, the components 102 and the cured resin 106 by lamination, i.e. the application of heat and/or pressure. Thereafter, access holes may be formed in the further double layer, for instance by laser drilling or mechanical drilling. By subsequently filling the access holes with a metal, for instance by plating, vertical through connections 178 (such as copper filled laser vias) may be formed for contacting metallic pads of the embedded components 102 through the further resin sheet 126.

**Figure 12** shows a cross-sectional view of a component carrier 104 according to another exemplary embodiment of the invention. More specifically, Figure 12 shows a component carrier 100 obtained based on the preform of Figure 6 by executing a process corresponding to Figure 7 and Figure 8. Although not shown, the obtained structure may then be subjected to further processing according to Figure 9 to Figure 11.

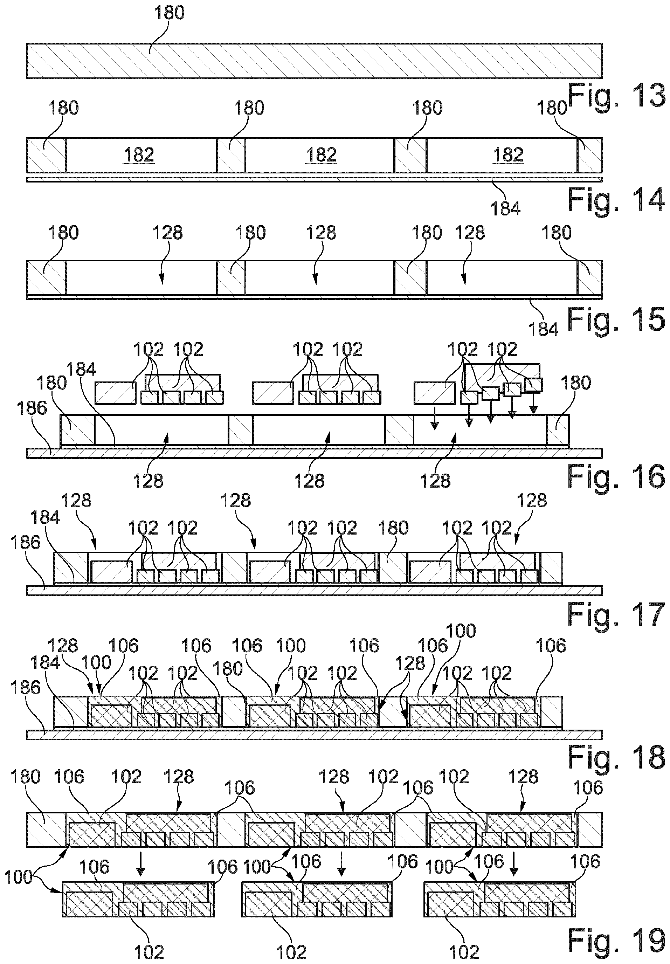

Figure 13 to Figure 19 show cross-sectional views of structures obtained during manufacturing a cluster 100 according to an exemplary embodiment of the invention. The cluster 100 may be configured to be inserted and subsequently embedded in a recess 116 provided in a preform of a component carrier 104. The construction of the cluster 100 including one or more components 102 may start with the definition of the cluster dimension, which is defined by the kind of components 102 included into it with their positioning in respect of the module requirements and to each other function.

Referring to **Figure 13****,** a base body 180 is provided. For example, base body 180 may be a metal sheet or can be made from other materials (for example a PCB core).

Referring to **Figure 14****,** receptacle holes 182 may be formed in the base body 180.

Once the cluster design is defined, a metal frame may be prepared based on the base body 180, through the formation of the holes 182 (having for example a rectangular, circular, oval, regular or irregular shape), preferably said holes being distributed on the base body 180 according to a specific pattern. This can be done by different technologies, preferred can be electro-erosion for controlled dimensioning and tolerances, but other methods can be used as well (such as milling, laser cutting, etching, routing etc.). Once finished, the metal frame can be coated with a poorly or non-adhesive coating, for instance made of PTFE, to enhance separation of the finally manufactured clusters 100. This may simplify removal of the epoxied component clusters 100.

Moreover, and now also referring to **Figure 15****,** an adhesive sheet 184 may be attached (for example by lamination) to a bottom main surface of the base plate 180 to thereby close the receptacle holes 182 for forming receptacles 128 with closed bottom.

Referring to **Figure 16****,** a support plate 186 may be connected to the bottom side of the adhesive sheet 184. For example, the support plate 186 may be a rigid plate, for instance a metal sheet. The support plate 186 may support clamping by a clamping tool (not shown). Thereafter, the components 102 may be placed in the receptacles 128. The result of this process is shown in **Figure 17****.**

Referring to **Figure 18****,** resin 106 is dispensed into the receptacles 128 (a vacuum chamber may be optionally used) to fill the spaces of the receptacles 128 in between the components 102 up to a pre-determined height. Thereby, the components 102 are encapsulated within an uncured flowable resin 106. Hence, the components 102 are surrounded by the uncured flowable resin 106 by inserting the components 102 and the uncured flowable resin 106 in the receptacles 128 defining part of an outline of the cluster 100, in particular the sidewalls. During this process, the components 102 are held in place by the adhesive sheet 184.

The dispensed resin 106 may be partially cured into a pre-gel B-stage. In a preferred embodiment, the filling of the receptacles 128 in the frame-like base body 180 is done with a liquid thermoset resin 106. More generally, this can be performed by screen printing, lamination or other techniques.

The frame-like base body 180 may then be placed into an oven and brought to a specific temperature for a specific time and/or exposed to UV light but not reaching the onset for gelling of the resin 106, stopping the polymerization cycle still in the B-stage range of the polymer matrix.

Referring to the upper portion of **Figure 19****,** the parts may be cooled down and once at room temperature or below, the clusters 100 are extracted from the metal matrix of the frame-like base body 180 (see bottom portion of Figure 19).

By transforming the uncured flowable resin 106 into an uncured reversible hardened state, the components 102 may be fixed in said still not fully cured solid resin 106. Transforming the uncured flowable resin 106 into the uncured reversible hardened state may be accomplished by a temperature decrease.

The clusters 100 can then be placed into media (such as a storage device) being suitable for following assembly operations into substrate panels. For this purpose, trays, tape and reel, or other technologies may be used. It may be advantageous to store these clusters 100 in a way compatible to slow down the polymerization cycle of the resin 106, for instance in a way for storing prepregs.

Since the monolithic block-type clusters 100 with the components 102 do not firmly adhere to the metal frame (due to the PTFE coating), the clusters 100 may be easily extracted from the frame after gelling, and the thermosetting compounds may prevent damage to the components 102 in the subsequent handling of the monolithic parts, i.e. the clusters 100.

The support plate 186 and the adhesive sheet 184 may be removed before extracting the individual clusters 100 from the receptacles 128 of the base body 180.

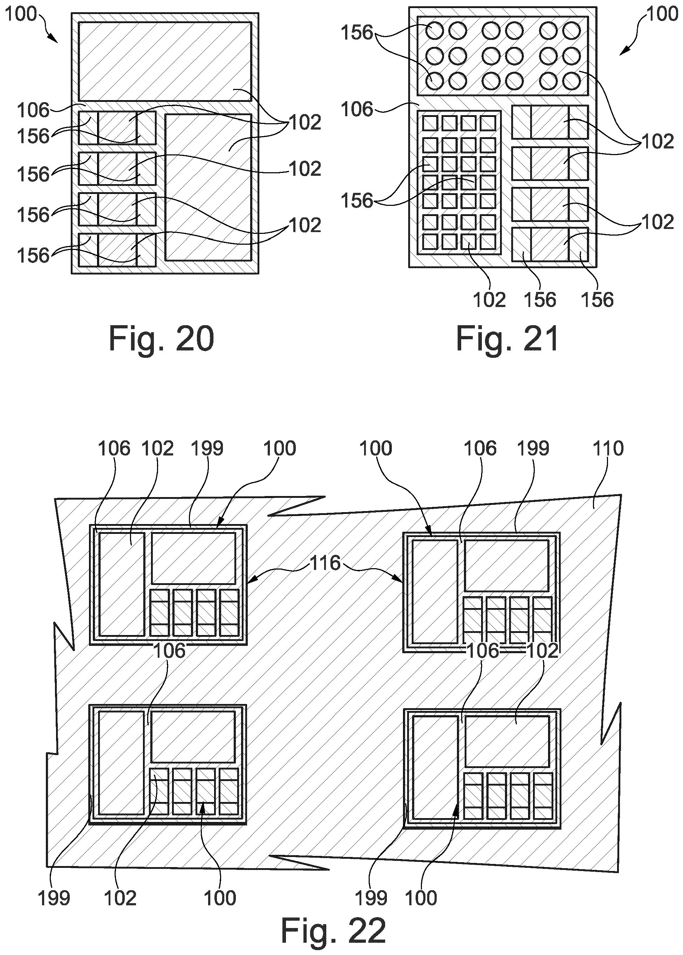

**Figure 20** and **Figure 21** show plan views of a cluster 100 according to an exemplary embodiment of the invention. More precisely, Figure 20 shows a top view of the cluster 100 manufactured according to Figure 13 to Figure 19, and Figure 21 shows a bottom view of that cluster 100. Metallic pads 156 for electrically contacting the respective electronic components 102 are illustrated as well.

**Figure 22** shows a plan view of a preform of a component carrier 104 according to another exemplary embodiment of the invention. The embodiment of Figure 22 differs from the embodiment of Figure 4 in particular in that, according to Figure 22, a plurality of recesses 116 are formed in a stack 110, and a respective cluster 100 with the properties described above referring to Figure 4 and Figure 5 is inserted in each of recesses 116.

**Figure 23** shows a plan view of a storage device 188 for storing and handling clusters 100 according to an exemplary embodiment of the invention.

As shown, a plurality of clusters 100 may be transferred from a tape and reel-type storage device 188 to recesses 116 of a stack 110, for instance into substrate cavities.

**Figure 24** shows a plan view of a storage device 188 for storing and handling clusters 100 according to another exemplary embodiment of the invention.

As shown, a plurality of clusters 100 may be transferred from a tray-type storage device 188 to recesses 116 of a stack 110, for instance into substrate cavities.

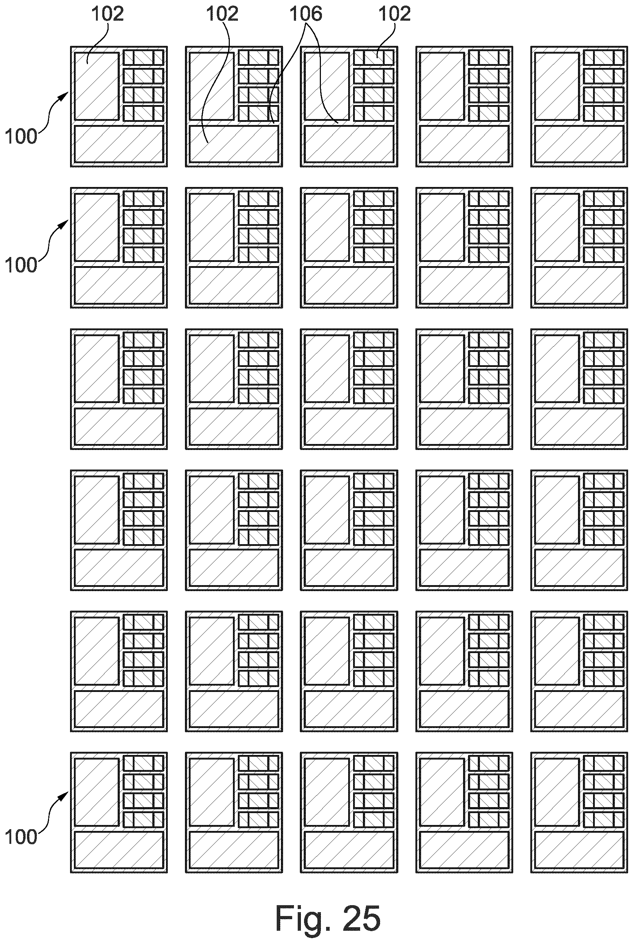

Figure 25 to Figure 29 show plan views of structures obtained during manufacturing clusters 100 for component carriers 104 according to an exemplary embodiment of the invention.

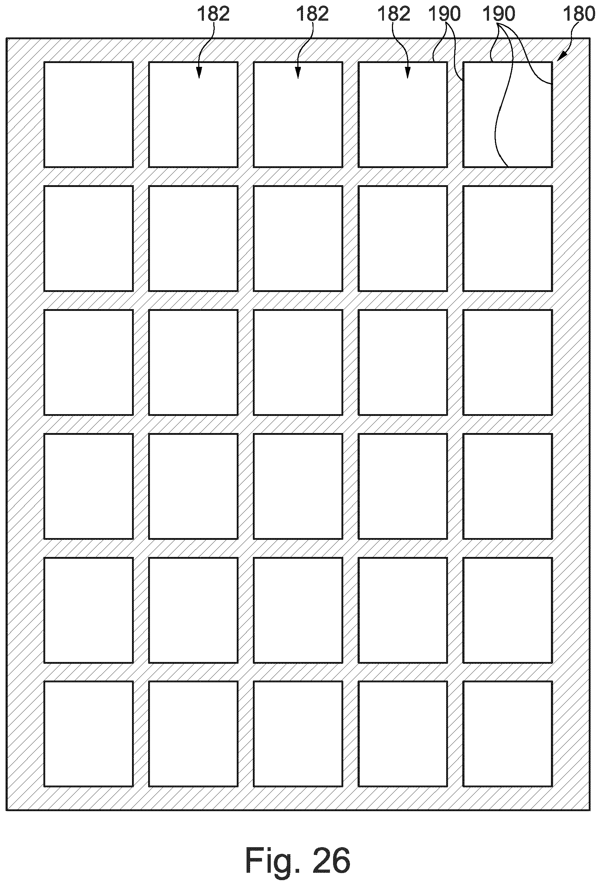

Referring to **Figure 25****,** a plurality of readily manufactured clusters 100 of the above-described type and arranged in a matrix like pattern are shown. These can be manufactured as described in the following:
Referring to **Figure 26****,** a base body 180 comprising a plurality of receptacle holes 182 is shown. Base body 180 may be embodied as a metal frame with cavities for later accommodating components 102 and resin 106. The receptacle holes 108 can be coated with a non-adhesive coating 190, for instance PTFE coated, with a thickness in a range from 40 µm to 60 µm. Advantageously, non-adhesive coating 190 may simplify removal of the clusters 100 from the base body 180 at the end of their manufacturing process.

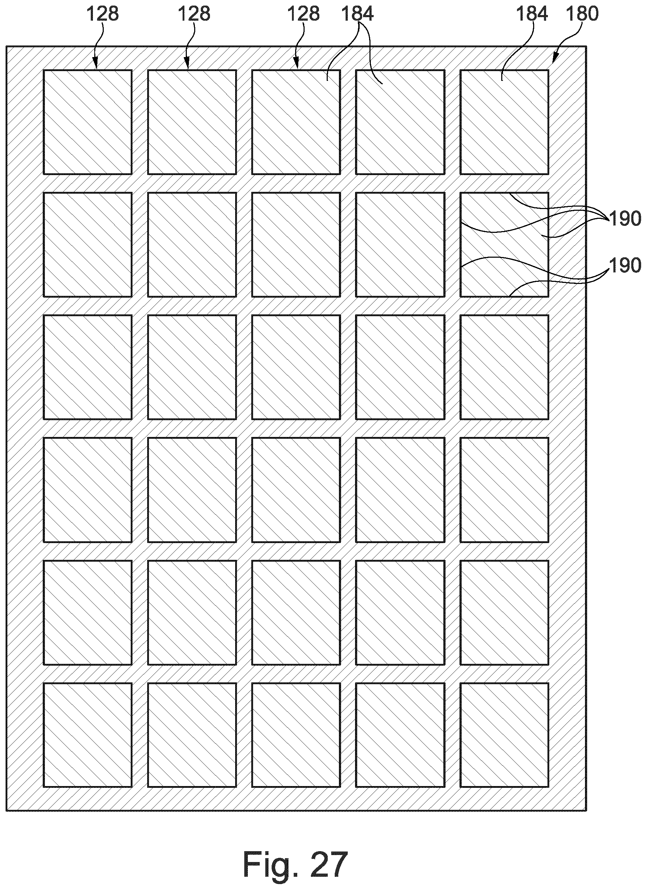

Referring to **Figure 27****,** the bottom of each receptacle hole 182 may be closed by an adhesive sheet 184 attached to a bottom side of the base body 180. For instance, adhesive sheet 184 may be an adhesive film laminated onto the base body 180. Adhesive sheet 184 may be used for temporarily fixing the components 102 after insertion into the receptacles 128.

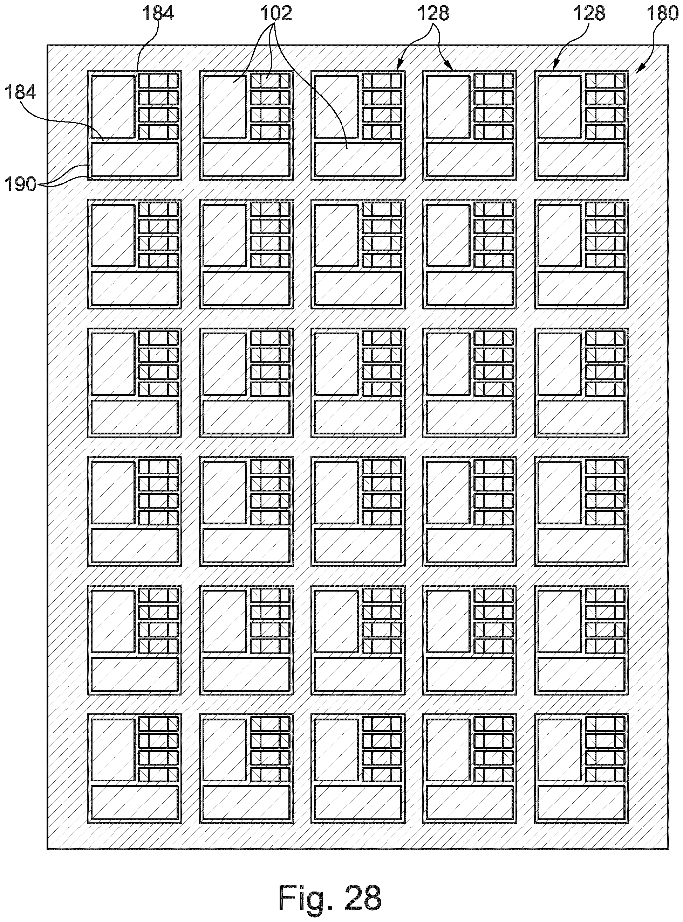

Referring to **Figure 28****,** components 102 are inserted into the receptacles 128 and temporarily fixed on the adhesive sheet 184.

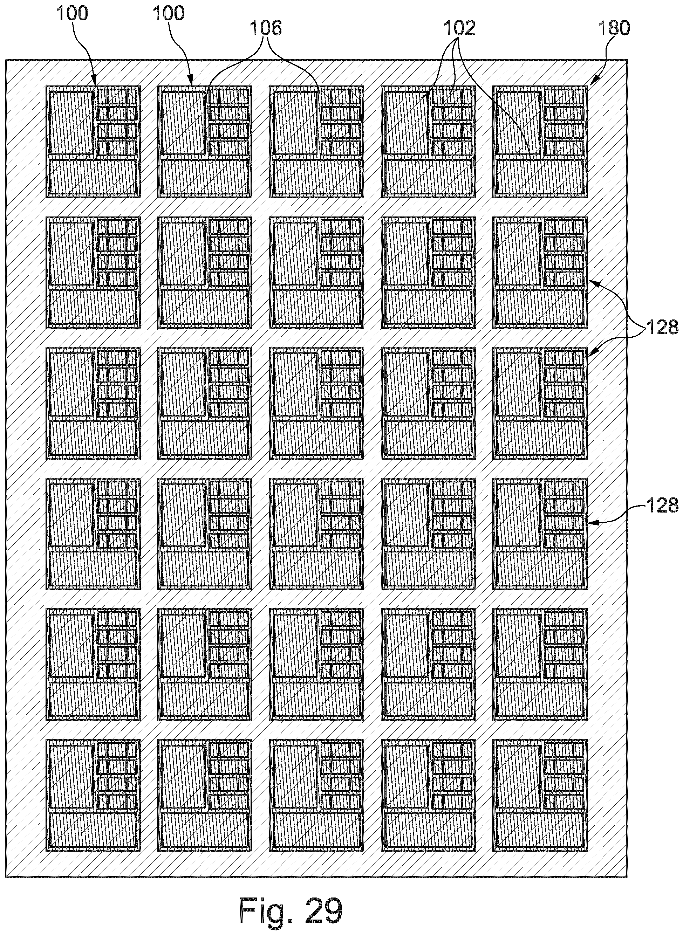

Referring to **Figure 29****,** the gaps in the cavities are filled with flowable uncured epoxy resin 106, which can then be hardened without being fully cured. Thereafter, the readily manufactured clusters 100 may be removed out of the receptacles 128.

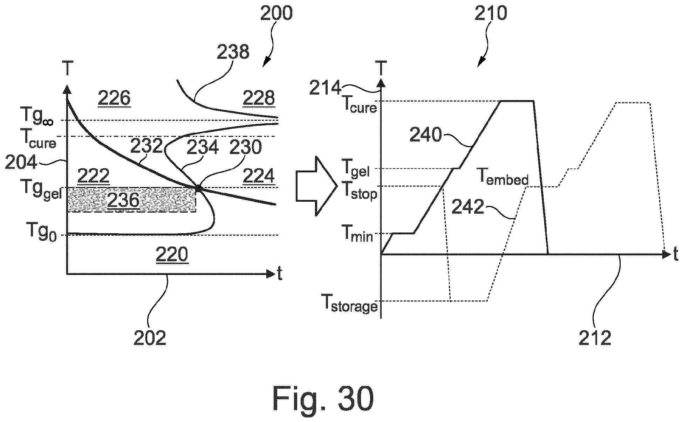

**Figure 30** shows a phase diagram 200 and a timing diagram 210 relating to a method of manufacturing a cluster 100 according to an exemplary embodiment of the invention. Both diagrams 200, 210 may be denoted as Time Temperature Transformation (TTT) diagrams.

Phase diagram 200 has an abscissa 202 along which the time, t, is plotted (log time). Along an ordinate 204 of phase diagram 200, the temperature, T, is plotted. Timing diagram 210 has an abscissa 212 along which the time, t, is plotted. Along an ordinate 214 of timing diagram 210, the temperature, T, is plotted.

The diagram 200 illustrates different areas corresponding to different phases of a resin, wherein lines between said areas indicate a phase transition. More precisely, reference sign 220 indicates an ungelled glass phase, reference sign 222 indicates a liquid phase, reference sign 224 indicates a gelled glass phase, reference sign 226 indicates a sol/gel rubber phase, and reference sign 228 indicates a char phase. A gel or vitrification point is indicated by reference sign 230. A gelation curve is indicated by reference sign 232, and a vitrification curve is indicated by reference sign 234. Area 236 indicates a process window, such as a preferred range of operation according to exemplary embodiments.

Based on Figure 30, it will be described how exemplary embodiments of the invention may take advantage of the thermoset material curing dynamics.

Thermoset resin (in particular resin 106 and/or resin 108) may form three-dimensional non-reversible networks during the transformation of the liquid resin to the solid. The dimensions of the resin layer may be fixed at the point at which the liquid is transformed to the gel, and continuation of cure may often transform the rubbery gel to a glassy material. The resultant solid has good mechanical properties up to the Tg temperature (glass transition), wherein the glass transition is the gradual and reversible transition in amorphous materials (or in amorphous regions within semicrystalline materials) from a hard and relatively brittle glassy state into a viscous or rubbery state as the temperature is increased.

The thermosetting material may pass through three different stages during its cure. Particularly, the thermosetting material completely uncured (when it is soluble and fusible) is in a so-called A-stage, this can also be in liquid form. When thermosetting material is cured, for example by heat, as a result its monomers may polymerize and/or cross-link into oligomers, and then into polymers (with its viscosity increasing, possibly after an initial decrease thereof). The thermosetting material partially cured below the gel point (when it is nearly insoluble, generally vitrified, but still thermoplastic) is in a so-called B-stage.

The thermosetting material completely cured (when it is insoluble and not thermoplastic any longer) is in a so-called C-stage.

In an embodiment of the present invention, the cure of the thermosetting material (i.e. of the resin 106 used to embed the components 102 into the cluster 100 forming a monolithic structure) may be stopped at the B-stage, before the thermosetting material reaches its gel point or area.

In this way, the embedding material is hard at touch and reasonably stiff to allow its processing with standard manufacturing operations. As a result, embedded structures (such as components 102) with three-dimensional configurations may be manufactured (with a few additional manufacturing steps) into a monolithic structure, with low effort, thereby making them suitable for mass production in high volume embedding applications.

Phase diagram 200 shows an isothermal transformation diagram of an example thermosetting material that may be used to implement a solution according to an embodiment of the invention. Referring to said phase diagram 200, also denoted as a Time-Temperature-Transformation (TTT) diagram, time t (in arbitrary units in logarithmic scale on the abscissa 202) required to obtain any transition of the thermosetting material is plotted versus a temperature T thereof (in arbitrary units on the ordinate 204). Therefore, each point of the phase diagram 200 indicates a condition of the thermosetting material when it is maintained at the corresponding temperature for the corresponding time.

The phase diagram 200 includes a gel curve (see reference sign 232) identifying the points in which the thermosetting material becomes a gel (at corresponding gel transition temperatures after corresponding times to gel), a glass curve (see reference sign 234) identifying the points in which the thermosetting material becomes glass-like (at corresponding glass transition temperatures after corresponding times to glass), and a char curve 238 identifying the points in which the thermosetting material decomposes into powder and/or gas (at corresponding char transition temperatures after corresponding times to char).

The transitions to gel (i.e. gelation) and to powder (i.e. decomposition) are irreversible, whereas the transition to glass (i.e. vitrification) is reversible. The gel curve (see reference sign 232) and the glass curve (see reference sign 234) intersect at a point (see reference sign 230), where the gelation and the vitrification coincide.

A portion of the phase diagram 200 before reaching both the gel curve and the glass curve defines a liquid region in which the thermosetting material is viscoelastic or liquid.

A portion of the phase diagram 200 after reaching the gel curve and before reaching the glass curve or the char curve defines a gel region in which the thermosetting material is gelled rubber.

A portion of the phase diagram 200 after reaching the glass curve defines a glass region in which the thermosetting material is glass. Particularly, a portion of the phase diagram 200 after reaching the glass curve from the liquid region defines an ungelled glass region in which the thermosetting material is ungelled glass, whereas a portion of the phase diagram 200 after reaching the glass curve from the gel region defines a gelled glass region in which the thermosetting material is gelled glass.

A portion of the phase diagram 200 after reaching the char curve defines a char region in which the thermosetting material is decomposed into powder and/or gas.

Three critical glass transition temperatures may be identified on the phase diagram 200, in which the thermosetting material becomes glass. Particularly, an uncured glass transition temperature Tg0 defines the maximum temperature (substantially above ambient temperature) at which the thermosetting material (when completely uncured) is always glass. Below the glass transition temperature Tg0, the cure is substantially negligible over time, so as to allow its storage at temperatures sufficiently below it (for example, by 20-50°C). A gel glass transition temperature Tggel defines the temperature at which gelation and vitrification coincide, as defined by the point 230 in the phase diagram 200. Between the glass transition temperatures Tg0 and Tggel, the thermosetting material vitrifies before gelifying. A cured glass transition temperature Tg∞ defines the maximum temperature at which the thermosetting material (when completely cured) vitrifies. Between the glass transition temperatures Tggel and Tg∞, the thermosetting material gelifies before vitrifying.

Timing diagram 210 (which may also be denoted as cure diagram) represents an example of a curing cycle, and a specifically selected cycle according to an exemplary embodiment of the invention, for a thermosetting material that may be used to implement a cluster 100 according to an embodiment of the invention.

The timing diagram 210 plots the temperature T, in arbitrary units on the ordinate 214, versus the time t, in arbitrary units on the abscissa 212. The cure curve defines a cure process or cycle of the thermosetting material (in particular resin 106) by its cure temperature over the cure time.

Generally, in every cure process the point (defined by time and temperature) at which the thermosetting material becomes a gel with its irreversible transformation thereto is called a gel point. From a molecular point of view, at the gel point the first covalent bonds connect across the thermosetting material. The thermosetting material at the gel point has a constant degree of cure (as defined by its chemical conversion) that is independent of the temperature (for example, of the order of 50-80%), i.e., gelation is an iso-conversional phenomenon.

Macroscopically, this involves an abrupt increase of viscosity and the development of elastic properties, with the first appearance of an equilibrium, i.e., time independent, shear modulus. The gel point may be calculated if the chemistry of the thermosetting material is known, or it may be determined with Dynamic Mechanical Rheological Testing (DMRT) techniques at the point where the tangent of the mechanical damping (tan δ) momentarily becomes independent of frequency (for example, by making dynamic oscillatory measurements simultaneously at different frequencies with a rheometer equipped with a multiwave mode).

Moreover, the point (time and temperature) at which the thermosetting material becomes a glass with its reversible transformation thereto is called a glass transition point. From a molecular point of view, the glass is an amorphous non-crystalline solid. The degree of cure of the thermosetting material at the glass point undergoes a significant decrease (for instance by 2-3 orders of magnitude) and it falls below the chemical reaction rate (as the reaction becomes controlled by the diffusion of reactants).

Macroscopically, the thermosetting material abruptly increases its rigidity and becomes relatively brittle. The glass transition point may be determined with Modulated-Temperature Differential Scanning calorimetry (MTDSC) techniques at the point where the heat capacity exhibits a step increase.

With reference now to a cure curve A indicated by reference sign 240, which shows a full cure cycle for an exemplary thermoset resin, during the corresponding cure process, the temperature is increased by heating the thermosetting material with a suitable heating rate that provides a regular and uniform cure thereof until the thermosetting material is completely cured (Tcure).

Particularly, the thermosetting material is initially heated to a minimum temperature Tmin (for example, 40-60° C, in 30-60 min.) so as to reach a minimum viscosity thereof. The temperature is then maintained constant at this value (for example, for 20-40 min.) to extend the period during which the thermosetting material has the minimum viscosity.

Later on, the thermosetting material is heated again to a gel temperature Tgel (for example, 100-120°C in 10-20 min.) so as to reach its gel point. In this phase, it may be useful to work at low barometric pressure before reaching the gel point to control its degassing. The temperature may be maintained constant at this value (for example, for 10-20 min.) to reduce surface porosity. The thermosetting material is heated again to a completion temperature Tcure (for example, 150-200° C in 30-60 min.) and then maintained at this value (for example, for 60-120 min.) so as to complete its cure. At this point, the thermosetting material is cooled down to the ambient temperature.

In the following, a curing cycle for a resin 106 used for creating a cluster 100 will be explained. Such a cluster 100 may be a monolithic structure which may be placed in a recess of a stack 110 of a component carrier 104 to be produced.

In embodiments of the invention, the B-stage condition of the resin material may play a role at two different phases and times of the implementation. Particularly, the thermosetting material properties when at the B-stage transitioning back into a viscous fluid, is capable of conforming to new shapes (in particular a recess 116 in a component carrier stack 110) maintaining the integrity of its properties. Moreover, the thermosetting material in A-stage (i.e. liquid form) may substantially fill any space that may be existing in the placed components arrays. This ability to conform to fill recess space and gaps prevents the creation of shear stress toward the placed components 102 which are held in position by the adhesive strength of adhesive tape 184. Therefore, the thermosetting material does not transmit strains (shear) to the components 102, with a beneficial effect on keeping them in the expected positions for the final process of connecting them with laser vias.

Looking at the combination of the curves in timing diagram 210, i.e. curve A and curve B (see reference sign 242) as explained below, the curing flow according to an exemplary embodiment for the formation of the monolithic components block (i.e. cluster 100) will be explained. The cure of the thermosetting material (i.e. resin 106) according to curve B is stopped at a pre-defined percentage of an activation energy required for reaching its gel point. As indicated above, the gelation is an iso-conversional phenomenon, so that the time to gel versus the gel temperature may be used to measure its activation energy. For example, the cure of the thermosetting material may be stopped at a stop temperature Tₛₜₒₚ equal to for instance, 78-82% (more generally 68-92%), such as 80%, of the gel temperature T_{gel}.

As a further improvement, as shown in the TTT diagram (i.e. phase diagram 200) and the cure cycles diagram (i.e. timing diagram 210), the stop temperature Tₛₜₒₚ is equal to or lower than the glass transition temperature Tg_{gel} at which gelation and vitrification coincide (hereinafter referred to as gel-glass transition temperature Tg_{gel}). For example, the stop temperature Tstop is equal to for instance, 83-87% (more generally 73-97%), such as 85% of the gel-glass transition temperature Tg_{gel}. In this way, a corresponding (with regard to temperature and time) identified process window 236 is available to use the thermosetting resin 106 in forming the monolithic cluster 100 before the gel point is reached.

The above-mentioned choice of the stop temperature Tₛₜₒₚ provides a proper tradeoff between the opposed requirements of sufficient mechanical characteristics of the thermosetting material holding the components 102 together, becoming compatible to automatic handling as a monolithic block, and becoming embeddable as a single cluster 100 at a later process step in the substrate manufacturing lamination cycle being capable to conform to recess spaces.

In an embodiment, as shown in the cure cycles diagram (i.e. timing diagram 210), and in particular in the curve B, the thermosetting material is then cooled rapidly (for example, in 5-10 min.) from Tₛₜₒₚ to a storage temperature T_{storage}, wherein the cure of the thermosetting material is quenched so as to obtain an ungelled glass.

For example, the storage temperature T_{storage} is 20-50° C below the glass transition temperature Tg0, so that the cure of the thermosetting material is substantially negligible over time thereby allowing its storage.

Later on, cluster 100 is inserted into a recess 116 of a stack 110, and during the lamination cycle the thermosetting resin 106 is heated again to a temperature T_{embed} so as to return the thermosetting resin 106 to a viscoelastic liquid, but this time may be constrained to conform with the substrate recess dimensions. The form temperature T_{embed} corresponds to the stop temperature Tₛₜₒₚ, for example, with the form temperature Tembed equal to for instance, 95-110% (more generally 85-120%), such as 110% of the stop temperature Tₛₜₒₚ at which the cluster 100 can be stopped in the construction temperature cycle. The cure process in the substrate lamination step then proceeds but it does re-activate the polymerization cycle of the block resin 106, which will blend with the substrate resin 108 so as to lock the component(s) 102 in monolithic cluster 100 within the stack 110, becoming a fully embedded unit into the substrate when the thermosetting material solidifies (as soon as its gel point is reached).

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants are possible which use the solutions shown and the principle according to the invention even in the case of fundamentally different embodiments.

## Claims

1. A cluster (100) configured to be inserted and subsequently embedded in a recess (116) provided in a component carrier (104), said cluster (100) comprising:
at least one component (102); and
an uncured solid resin (106) encapsulating said component (102);
said uncured solid resin (106), or said at least one component (102) and said uncured solid resin (106), forming the exterior surface of said cluster (100).

2. The cluster (100) according to claim 1, wherein the cluster (100) comprises a plurality of components (102) encapsulated in the uncured solid resin (106).

3. The cluster (100) according to claim 1 or 2, wherein the uncured solid resin (106) covers at least part of sidewalls (154) and/or at least part of a top wall and/or at least part of a bottom wall of the at least one component (102).

4. A method of manufacturing a cluster (100) configured to be inserted and subsequently embedded in a recess (116) provided in a component carrier (104), wherein the method comprises:
encapsulating at least one component (102) by an uncured flowable resin (106); and
thereafter transforming the uncured flowable resin (106) into an uncured reversible hardened state for fixing the at least one component (102) in said resin (106).

5. A component carrier (104), wherein the component carrier (104) comprises:
a stack (110) comprising at least one electrically conductive layer structure (112) and at least one electrically insulating layer structure (114);
a recess (116) formed in the stack (110); and
at least one component (102) embedded in the recess (116);
wherein the recess (116) is provided with a resin (106) encapsulating the at least one component (102), said resin (106) being fixed to said stack (102) by a further resin (108) provided in said recess (116);
wherein the interface between the resin (106) and the further resin (108) extends along an irregular boundary surface (118).

6. The component carrier (104) according to claim 5, wherein the at least one component (102) is exposed at a side, in particular at a bottom side, beyond the resin (106) and the further resin (108).

7. The component carrier (104) according to claim 5 or 6, wherein the at least one component (102) is partially in contact with the further resin (108) at an extension of said irregular boundary surface (118).

8. The component carrier (104) according to any of claims 5 to 7, wherein the irregular boundary surface (118) is a three-dimensionally curved surface.

9. The component carrier (104) according to any of claims 5 to 8, wherein the irregular boundary surface (118) comprises a dimple, for example a plurality of dimples, between a sidewall (152) of the recess (116) delimiting said resin (106) and/or said further resin (108) and one of the at least one component (102), and/or between neighbouring components (102).

10. The component carrier (104) according to any of claims 5 to 9, wherein the irregular boundary surface (118) comprises a meniscus, for example a plurality of meniscus, between a sidewall (152) of the recess (116) delimiting said resin (106) and/or said further resin (108) and one of the at least one component (102), and/or between neighbouring components (102).

11. The component carrier (104) according to any of claims 5 to 10, wherein at least part of gaps of the recess (116) between the at least one component (102) and the stack (110) is filled partially with the resin (106) and partially with the further resin (108).

12. The component carrier (104) according to any of claims 5 to 11, wherein at least two components (102) are embedded in the recess (116) encapsulated in the resin (106).

13. A method of manufacturing a component carrier (104), wherein the method comprises
forming a recess (116) in a stack (110) comprising at least one electrically conductive layer structure (112) and at least one electrically insulating layer structure (114);
inserting a cluster (100) according to any of claims 1 to 6 in the recess (116); and
subsequently transforming the uncured solid resin (106) into a flowable state so that the transformed resin (106) interacts with the stack (102) by the flowing resin (106); and
thereafter further transforming the transformed resin (106) into a cured solid state.

14. The method according to claim 13, wherein the method comprises filling part of gaps of the recess (116) between the at least one component (102) and the stack (110) by said cured resin (106) and filling at least another part of said gaps by a further resin (108).

15. The method according to claim 13 or 14, wherein the method comprises curing said resin (106) and curing said further resin (108) simultaneously.
